# EUROPÄISCHE PATENTSCHRIFT

(11) **EP 0 814 513 B1**
(45) Veröffentlichungstag und Bekanntmachung des Hinweises auf die Patenterteilung: **16.08.2006**
(21) Anmeldenummer: 97108816.6
(22) Anmeldetag: 02.06.1997
(51) Int. Cl.: H01L 27/02, H01L 27/092

(54) **Monolithisch integrierte Mehrfachbetriebsartenschaltung**
Monolithically integrated multiple operating mode circuit
Circuit monolithique intégré avec plusieurs modes d'opération

(30) Priorität: 19.06.1996 DE 19624474
(43) Veröffentlichungstag der Anmeldung: 29.12.1997
(73) Patentinhaber: SGS-THOMSON MICROELECTRONICS GMBH, 85630 Grasbrunn (DE)
(72) Erfinder: Gerner, Wolfgang, 85886 Poing (DE)
(74) Vertreter: Hirsch, Peter

(56) Entgegenhaltungen:
- EP-A- 0 556 605
- WO-A-89/06048
- US-A- 4 733 105
- US-A- 5 444 397
- US-A- 5 521 546
- PATENT ABSTRACTS OF JAPAN vol. 018, no. 507 (E-1609), 22. September 1994 (1994-09-22) -& JP 06 177335 A (NIPPON STEEL CORP), 24. Juni 1994 (1994-06-24)

## Beschreibung

Die Erfindung betrifft eine monolithisch integrierte Mehrfachbetriebsartenschaltung, die in einem Substrat oder in einer epitaktischen Schicht einer Halbleiterscheibe eine Wannenzone (in Anlehnung an den englischen Sprachgebrauch auch häufig Well genannt) aufweist, in der die Drainzone und die Sourcezone eines MOS-Transistors und eine Wannenkontaktierungszone gebildet sind.

In einer Wannenzone gebildete MOS-Transistoren verwendet man vorwiegend in integrierten Halbleiterschaltungen, die sowohl N-Kanal-MOS-Transistoren als auch P-Kanal-MOS-Transistoren aufweisen. Da das Substrat beziehungsweise die epitatktische Schicht üblicherweise von einem einheitlichen Leitfähigkeitstyp ist, kann man darin nicht sowohl die Drain- und Source-Zonen eines N-Kanal-MOS-Transistors als auch die Source- und Drain-Zonen eines P-Kanal-MOS-Transistors bilden. Aus diesem Grund wird in dem Substrat bzw. in der epitaktischen Schicht eines ersten Leitfähigkeitstyps eine Wannenzone entgegengesetzten Leitfähigkeitstyps gebildet, in welcher einer der beiden MOS-Transistortypen gebildet wird, während im Substrat bzw. in der epitaktischen Schicht der andere MOS-Transistortyp erzeugt wird.

Es gibt auch integrierte Halbleiterschaltungen, die in einem Substrat oder in einer epitaktischen Schicht sehr niedriger Leitfähigkeit eines bestimmten Leitfähigkeitstyps sowohl eine Wannenzone des gleichen Leitfähigkeitstyps als auch eine Wannenzone des entgegengesetzten Leitfähigkeitstyps aufweisen. Die eine Wannenzone dient der Aufnahme des einen MOS-Transistor-Typs und die andere Wanne dient der Aufnahme des entgegengesetzten MOS-Transistor-Typs. Die beiden Wannenzonen werden von dem dazwischen befindlichen Bereich des Substrats bzw. der epitaktischen Schicht sehr niedriger Leitfähigkeit quasi isoliert.

Im folgenden wird der Einfachheit halber nur noch von Substrat gesprochen, wobei von diesem Begriff immer die Möglichkeit umfaßt sein soll, daß es sich dabei auch um eine epitaktische Schicht handeln kann.

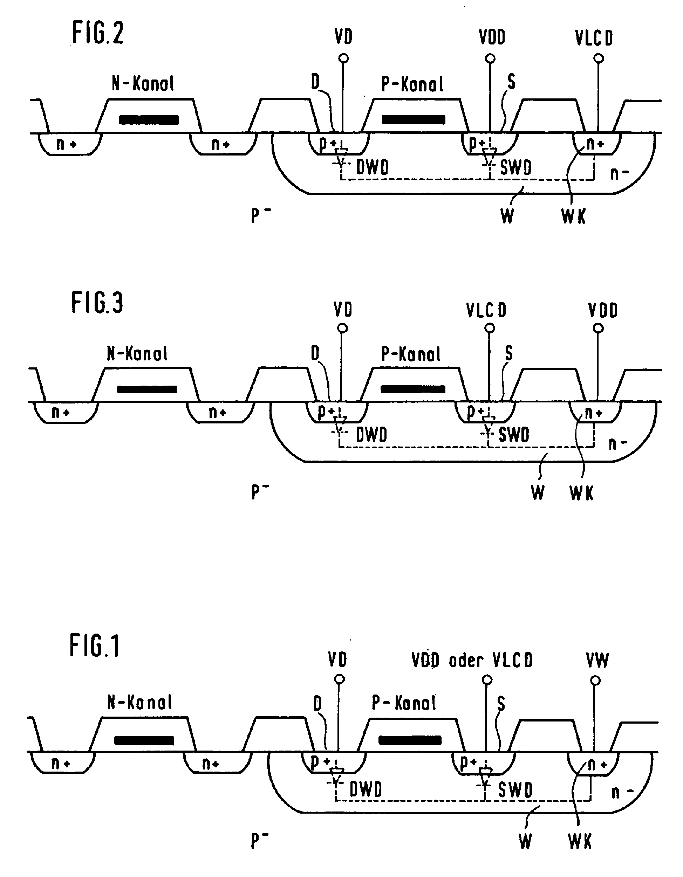

Ein in der Praxis häufig vorkommendes Beispiel ist eine CMOS-Schaltung mit einem p⁻-Substrat, in dem die n⁺⁻Source- und Drain-Zonen eines N-Kanal-MOS-Transistors gebildet sind sowie eine n⁻-Wannenzone, in der sich die p⁺-Drain- und Source-Zonen eines P-Kanal-MOS-Transistors und eine n⁺-leitende Wannenkontaktierungszone befinden. Eine derartige Halbleiterstruktur ist ausschnittsweise und schematisiert in den Figuren 1 bis 3 dargestellt. In diesen Figuren sind die Wannenzone mit W, die Wannenkontaktierungszone mit WK, die Drainzonen mit D und die Sourcezonen mit S bezeichnet. Die Halbleiterübergänge zwischen den Drain- und Source-Zonen bilden mit dem Halbleitermaterial, in das sie eingebettet sind, Halbleiterdioden, die je nach der Vorspannung, die über diesen Halbleiterübergängen liegt, sperren oder leiten können. In den Figuren 1 bis 3 sind solche Dioden, im folgenden parasitäre Dioden genannt, für den in der Wannenzone W befindlichen P-Kanal-MOS-Transistor gestrichelt angedeutet. Dabei ist die Drain-Wannen-Diode mit DWD und die Source-Wannen-Diode mit SWD bezeichnet.

Es gibt Schaltungsanordnungen, beispielsweise Treiberschaltungen für Flüssigkristallanzeigevorrichtungen (LCD), denen einerseits ein positives Versorgungsspannungspotential VDD einer Versorungsspannungsquelle und andererseits eine positive LCD-Betriebsspannung VLCD zugeführt werden. Während das Versorgungsspannungspotential VDD im allgemeinen einen konstanten Potentialwert aufweist, ist die LCD-Betriebsspannung VLCD meist veränderbar, beispielsweise um einen gewünschten Kontrast einstellen zu können oder zur Temperaturnachführung, mittels welcher die Auswirkungen von Temperaturschwankungen kompensiert werden. Die Veränderbarkeit von VLCD relativ zu VDD kann dazu führen, daß VLCD zum einen Zeitpunkt größer und zum anderen Zeitpunkt kleiner ist als VDD.

In der Praxis gibt es die beiden in den Figuren 2 und 3 gezeigten Möglichkeiten, entweder die Source-Zone S des in der Wannenzone W befindlichen P-Kanal-MOS-Transistors mit VDD und die Wannenkontaktierungszone WK mit VLCD zu beaufschlagen (Fig. 2) oder umgekehrt die Source-Zone dieses P-Kanal-MOS-Transistors mit VLCD und die Wannenkontaktierungszone WK mit VDD zu beaufschlagen (Fig. 3).

Normalerweise sollen die beiden parasitären Dioden DWD und SWD gesperrt sein, um Quer- und Leckströme zu vermeiden, die zu einer Verfälschung des elektrischen Verhaltens der integrierten Halbleiterschaltung führen können, und dies möglicherweise so weitgehend, daß diese Halbleiterschaltung nicht mehr die vorgeschriebene Spezifikation erfüllt.

Damit die parasitäre Diode SWD gesperrt bleibt, muß im Fall der Figur 2 die Bedingung VDD s VLCD erfüllt sein, während im Fall der Figur 3 die Bedingung VLCD s VDD erfüllt sein muß. Das heißt, keine der beiden in den Figuren 2 und 3 gezeigten Alternativen erlaubt es, die Werte der beiden Potential VDD und VLCD unabhängig voneinander zu machen.

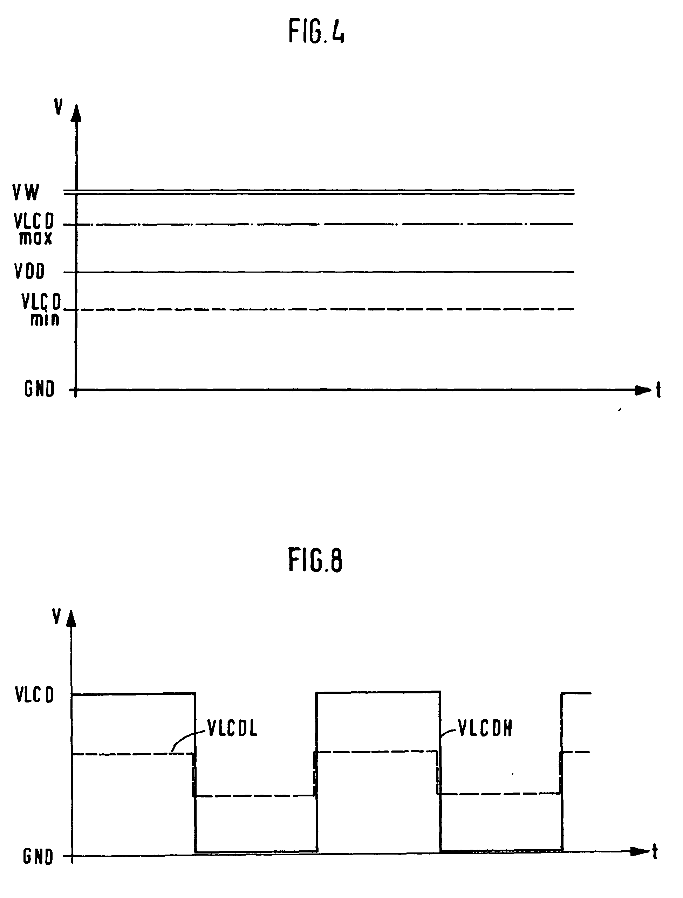

Figur 4 zeigt ein Beispiel für Spannungsverläufe von VDD und VLCD. Dabei ist angenommen, daß-VLCD, wenn dessen Wert in der gewünschten Weise veränderbar sein soll, zwischen einem Minimalwert VLCDmin und einem Maximalwert VLCDmax liegt, während VDD ein dazwischen befindliches konstantes Potential aufweist. Diesen gewünschten Veränderungsbereich von VLCD kann man aber weder im Fall der Fig. 2 noch im Fall der Fig. 3 realisieren, wenn man sicherstellen möchte, daß die parasitäre Diode SWD gesperrt bleibt. Im Fall der Fig. 2 kann man für VLCD nur den Bereich zwischen VDD und VLCDmax ausnutzen, während man im Fall der Fig. 3 für VLCD nur den Bereich zwischen VLCDmin und VDD ausnutzen kann.

Gleiche Betrachtungen kann man für eine Halbleiterschaltung anstellen, bei welcher Substrat bzw. epitaktische Schicht, Wannenzone W, Wannenkontaktierungszone WK, Drainzone D und Sourcezone S Leitfähigkeitstypen aufweisen, die den in den Figuren 1 bis 3 gezeigten Leitfähigkeitstypen entgegengesetzt sind. Eine derartige Halbleiterschaltung wird üblicherweise mit negativen Versorgungs- bzw. Betriebsspannungen betrieben, die genauso wie in den anhand von Figuren 2 und 3 betrachteten Beispielen nicht voneinander unabhängig sein können, wenn sichergestellt sein soll, daß die parasitäre Diode SWD gesperrt bleibt.

Für die parasitären Dioden DWD gelten ähnliche Überlegungen wie für die parasitären Dioden SWD. Da der Betrag des an der Drainzone D anliegenden Potentials VD wegen des Spannungsabfalls über der Kanalstrecke normalerweise niedriger ist als der Wert des an der Sourcezone liegenden Potentials, bleibt die parasitäre Diode DWD gesperrt, wenn solche Bedingungen für VDD und VLCD eingehalten sind, daß die parasitäre Diode SWD gesperrt bleibt.

Aus der US-A-5 444 397 ist es bekannt, bei einer Halbleiterstruktur, bei welcher ein P-Kanal-MOS-Transistor in einer Wannenzone gebildet ist und an die Drainzone alternativ eines von zwei verschiedenen Potentialen gleichen Vorzeichens anlegbar ist, wobei diese Potentiale unterschiedliche Beträge aufweisen, an die Wannenkontaktierungszone ein Potential anzulegen, das gleiche Vorzeichen wie die beiden alternativ an die Drainzone anlegbaren Potentiale aufweist und einen Betrag besitzt, der so groß ist wie der maximale Wert, den die beiden alternativ an die Drainzone anlegbaren Potentiale annehmen können.

Im Fall des anhand der Figuren 2 und 3 betrachteten Beispiels, bei welchem an die Source-Zone eines in einer Wannenzone befindlichen P-Kanal-MOS-Transistors alternativ ein Versorgungsspannungspotential VDD oder ein LCD-Betriebspotential VLCD mit Spannungswerten und -bereichen gemäß Fig. 4 anlegbar ist, führt die Anwendung der Lehre der US-A-4 544 397 dazu, daß an die Wannenkontaktierungszone ein Potential angelegt wird, das einerseits positiv ist und dessen Potentialwert andererseits gleich oder größer ist als VDD oder VLCDmax, je nachdem, ob der Betrag von VDD oder der Betrag von VLCDmax größer ist.

Die beiden Potentiale, die alternativ beispielsweise an die Sourcezone eines in einer Wannenzone gebildeten MOS-Transistors anlegbar sind, können vollständig unabhängig voneinander gewählt und nach Wunsch relativ zueinander veränderbar gemacht werden, ohne daß es zum unerwünschten Leiten der parasitären Dioden kommt. Es braucht lediglich darauf geachtet zu werden, daß das an die Wannenkontaktierungszone angelegte Potential einen Wert aufweist, der gleich oder größer ist als der Betrag, den die beiden alternativ an die Sourcezone anlegbaren Potentiale maximal annehmen können.

Mit der Erfindung wird eine Schaltung verfügbar gemacht, die sich für unterschiedliche Betriebsarten wahlweise in einen Eingangsstufenbetrieb oder in einen Ausgangsstufenbetrieb steuern läßt, in denen auf die Source- oder Drainzonen von in mindestens einer Wannenzone gebildeten MOS-Transistoren unterschiedliche Potentiale gelangen können, ohne daß es zu Problemen der geschilderten Art kommt.

Eine erfindungsgemäße Mehrfachbetriebsartenschaltung dieser Art ist in Anspruch 1 angegeben und kann gemäß Anspruch 2 oder 3 ausgebildet sein.

Die Erfindung wird nun anhand einer Ausführungsform näher erläutert. In den Zeichnungen zeigen:
Fig. 1 eine erste Ausführungsform einer monolithisch integrierten Halbleiterschaltung mit - einem Spannungsbetrieb, der Probleme mit parasitären Dioden vermeidet;
Fig. 2 eine erste Alternative eines Betriebs einer derartigen Halbleiterschaltung, bei welchem Probleme mit parasitären Dioden auftreten können;
Fig. 3 eine zweite Alternative eines Betriebs einer derartigen Halbleiterschaltung, bei welchem Probleme mit parasitären Dioden auftreten können;
Fig. 4 Spannungswerte, wie sie bei den Halbleiterschaltungen der Figuren 1 bis 3 auftreten können;

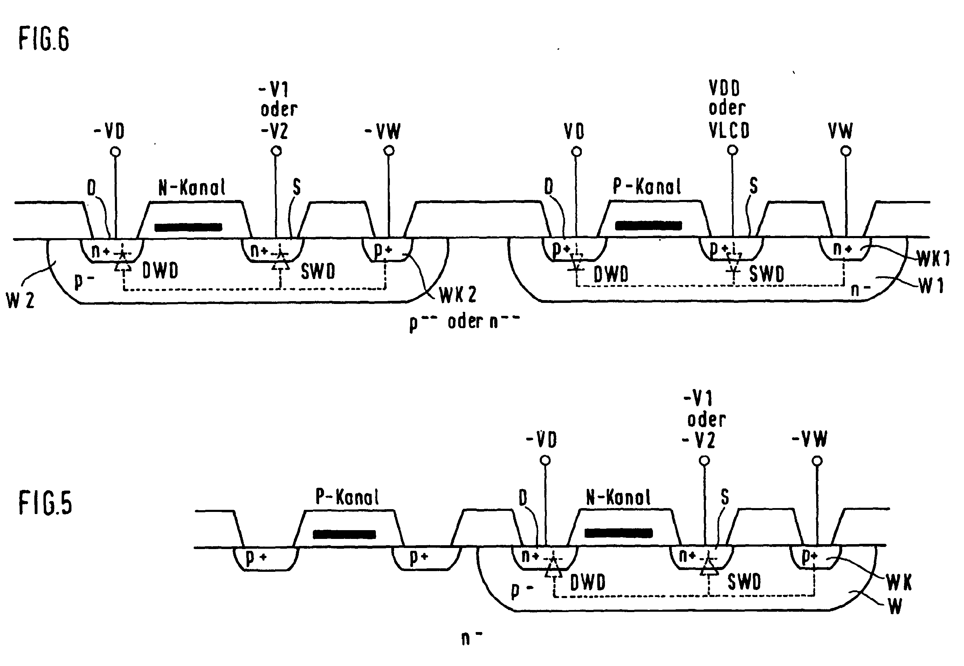

Fig. 5 eine zweite Ausführungsform einer monolithisch integrierten Halbleiterschaltung mit einem Spannungsbetrieb, der Probleme mit parasitären Dioden vermeidet;
Fig. 6 eine dritte Ausführungsform einer monolithisch integrierten Halbleiterschaltung in Form einer Doppel-Wannen-Schaltung mit einem Spannungsbetrieb, der Probleme mit parasitären Dioden vermeidet;

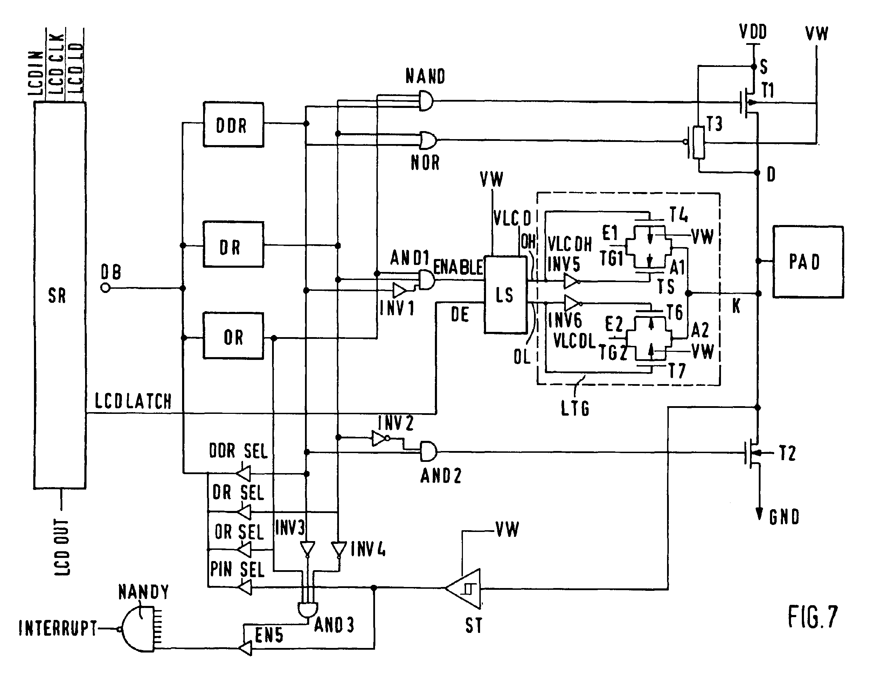

Fig. 7 ein Ausführungsbeispiel einer erfindungsgemäßen Mehrfachbetriebsartenschaltung; und
Fig. 8 zwei Spannungsverläufe, die bei der in Fig. 7 gezeigten Mehrfachbetriebsartenschaltung auftreten können.

Fig. 1 zeigt eine monolithisch integrierte Halbleiterschaltung mit der bereits anhand der Figuren 2 und 3 gezeigten Struktur, jedoch mit einer Spannungsbeaufschlagung der Wannenkontaktierungszone WK mit einer Wannenspannung VW, die, wie es in Fig. 4 gezeigt ist, einen Betrag aufweist, der oberhalb des Potentialwertes von VLCDmax liegt. Auf diese Weise ist sichergestellt, daß die beiden parasitären Dioden SWD und DWD immer gesperrt bleiben, unabhängig davon, ob an die Sourcezone S VDD oder VLCD anglegt wird und wie weit sich VDD und VLCD relativ zueinander ändern.

Fig. 5 zeigt bezüglich des Leitfähigkeitstyps das Gegenstück zu der in Fig. 1 gezeigten Haltleiterstruktur. Das heißt, die Leitfähigkeitstypen der einzelnen Schichten und Zonen, die Kanal-Typen der beiden gezeigten MOS-Transistoren und die Vorzeichen der Potentiale sind entgegengesetzt zu der in Fig. 1 gezeigten Ausführungsform. Damit die beiden parasitären Dioden DWD und SWD gesperrt bleiben, wird an die Wannenkontaktierungszone WK ein Wannenpotential -VW angelegt, dessen Betrag höher ist als der Betrag, den die alternativ an die Sourcezone anlegbaren beiden Potentiale -V1 und -V2 maximal annehmen können.

Fig. 6 zeigt eine Halbleiterschaltung mit einer Doppel-Wannen-Struktur. In ein Substrat mit relativ niedriger p- oder n-Leitfähigkeit werden eine n-leitende Wannenzone W1 und eine p-leitende Wannenzone W2 eingebracht, in denen ein P-Kanal-MOS-Transistor und eine Wannenkontaktierungszone WK1 entsprechend der in Fig. 1 gezeigten Struktur bzw. ein N-Kanal-MOS-Transistor und eine Wannenkontaktierungszone WK2 entsprechend der in Fig. 5 gezeigten Struktur gebildet sind. An die Wannenkontaktierungszonen WK1 und WK2 werden Potentiale angelegt, die den im Zusammenhang mit Fig. 1 für VW bzw. den im Zusammenhang mit Fig. 5 für -VW erläuterten Bedingungen genügen.

Fig. 7 zeigt ein Beispiel einer erfindungsgemäß aufgebauten monolithisch integrierten Mehrfachbetriebsartenschaltung, welche derart betrieben wird, daß die geschilderten Probleme mit parasitären Dioden nicht auftreten. An diese Mehrfachbetriebsartenschaltung wird einerseits ein positives Versorgungsspannungspotential VDD und andererseits eine Flüssigkristallanzeigen-Betriebsspannung VLCD angelegt, wobei diese beiden Potentiale beispielsweise das in Fig. 4 gezeigte, relativ zueinander veränderbare Verhältnis zueinander aufweisen. Diese Mehrfachbetriebsartenschaltung weist eine Reihe von P-Kanal-MOS-Transistoren auf, die je in einer Wannenstruktur gemäß Fig. 1 gebildet sind und deren Source-Zonen entweder VDD oder VLCD zugeführt wird. Teilweise sind diese P-Kanal-Transistoren dargestellt, teilweise befinden sie sich in komplexeren Schaltungsblöcken, ohne selbst gezeigt zu sein. Den Wannenkontaktierungszonen aller jener P-Kanal-Transistoren, die in elektrischer Verbindung mit einer dem Anschluß an externe Schaltungskomponenten dienenden Kontaktierungsfläche PAD stehen oder in eine solche Verbindung bringbar sind, wird ein Wannenpotential VW zugeführt, das den erfindungsgemäßen und beispielsweise in Fig. 4 gezeigten Bedingungen hinsichtlich seines Verhältnisses zu VDD und VLCD entspricht. Dadurch ist sichergestellt, daß unabhängig davon, ob an den Sourceanschluß eines derartigen P-Kanal-MOS-Transistors VDD oder VLCD angelegt wird, und unabhängig davon, ob VLCD permanent oder vorübergehend kleiner oder größer ist als VDD, dessen parasitäre Dioden DWD und SWD immer gesperrt bleiben.

Bei der in Fig. 7 gezeigten Mehrfachbetriebsartenschaltung handelt es sich um eine Schaltung, die wahlweise entweder als Ausgangsstufe oder als Eingangsstufe einer Schaltungsanordnung betreibbar ist. Im Betrieb als Ausgangsstufe kann sie beispielsweise betrieben werden als:
- Treiberschaltung für eine Flüssigkristallanzeigevorrichtung;
- LED-Ansteuerschaltung;
- Ansteuerschaltung für eine Last beispielsweise in Form eines elektrischen Widerstandes oder eines Relais.

Im Betrieb als Eingangsschaltung kann
- Dateninformation empfangen und an einen Datenbus weitergegeben werden;
- der momentane elektrische Zustand einer Schaltungskomponente detektiert werden, die an die Kontaktierungsfläche PAD angeschlossen ist und ihren elektrischen Zustand ändern kann.

Welchen dieser Betriebszustände die in Fig. 7 gezeigte Schaltung jeweils einnimmt, hängt von Daten ab, die jeweils in eine Registereinrichtung mit Registern DDR, DR und OR eingegeben sind. Bei DDR handelt es sich um ein Datenflußrichtungsregister zur Speicherung von die Datenflußrichtung in der Mehrfachbetriebsartenschaltung festlegenden Steuerdaten. Mit DR ist ein Datenregister zur Zwischenspeicherung von zu übertragenden Datensignalen bezeichnet. Bei OR handelt es sich um ein Optionsregister zur Speicherung von die möglichen Betriebsarten auswählenden Betriebsartendaten. Eingänge von DDR, DR und OR sind mit einem Datenbus DB verbunden, über den sie ihre Daten erhalten. Ausgänge von DDR, DR und OR sind mit Eingängen einer Logikschaltunganordnung verbunden, die eine NAND-Verknüpfungsschaltung NAND, eine NOR-Verknüpfungsschaltung NOR, eine erste UND-Verknüpfungsschaltung AND1, eine zweite UND-Verknüpfungsschaltung AND2 und eine dritte UND-Verknüpfungsschaltung AND3 enthält. Die Verknüpfungsschaltung NAND weist drei Eingänge auf, von denen ein erster mit dem Ausgang von DDR, ein zweiter mit dem Ausgang von DR und ein dritter mit dem Ausgang von OR verbunden ist. Die Verknüpfungsschaltung NOR weist zwei Eingänge auf, von denen einer mit dem Ausgang von DDR und der andere mit dem Ausgang von DR verbunden ist. Die Verknüpfungsschaltung AND1 weist drei Eingänge auf, von denen einer über einen ersten Inverter INV1 mit dem Ausgang von DDR, ein zweiter mit dem Ausgang von DR und ein dritter mit dem Ausgang von OR verbunden ist. Die Verknüpfungsschaltung AND2 weist zwei Eingänge auf, von denen einer mit dem Ausgang von DDR und der andere über einen zweiten Inverter INV2 mit dem Ausgang von DR verbunden ist. Die Verknüpfungsschaltung AND3 weist drei Eingänge auf, von denen ein erster mit dem Ausgangt von OR, ein zweiter über einen dritten Inverter INV3 mit dem Ausgang von DDR und ein dritter über einen vierten Inverter INV4 mit dem Ausgang von DR verbunden ist.

Die Mehrfachbetriebsartenschaltung der Fig. 7 weist eine CMOS-Ausgangsstufe mit einem mit VDD verbundenen hochpotentialseitigen P-Kanal-MOS-Transistor T1 und einem mit einem Masseanschluß GND verbundenen niederpotentialseitigen N-Kanal-MOS-Transistor T2 auf. In einem Schaltungspunkt K sind die in Reihe geschalteten Transistoren T1 und T2 miteinander und mit der Kontaktierungsfläche PAD verbunden. Das Gate von T1 ist mit dem Ausgang der Verknüpfungsschaltung NAND verbunden, während das Gate von T2 mit dem Ausgang der Verknüpfungsschaltung AND2 verbunden ist.

Der Transistor T1 ist von einem Widerstands-MOS-Transistor T3 überbrückt, dessen Gate mit dem Ausgang der Verknüpfungsschaltung NOR verbunden ist und der als schaltbarer Widerstand dient, der im leitend geschalteten Zustand einen definierten Ohmschen Widerstand, beispielsweise von etwa 100 KΩ, darstellt und im nicht leitend geschalteten Zustand in für MOS-Transistoren üblicher Weise einen praktisch unendlichen Widerstand darstellt.

Zwischen den Ausgang der Verknüpfungsschaltung AND1 und den Schaltungspunkt K ist eine Reihenschaltung mit einem Pegelschieber LS und einem LCD-Transfergate LTG geschaltet. Der Pegelschieber LS hat zwei Eingänge, nämlich einen mit dem Ausgang von AND1 verbundenen ENABLE-Eingang und einen Dateneingang DE, der mit einem Ausgang LCD LATCH eines LCD-Schieberegisters SR verbunden ist. Der Pegelschieber LS weist zwei Ausgänge OH und OL auf, die mit einem oberen bzw. einem unteren von zwei parallelen Schaltungszweigen des LCD-Transfergates LTG verbunden sind. Der obere dieser beiden Schaltungszweige weist eine Parallelschaltung aus einem fünften Inverter INV5 und einem ersten Transistorgate TG1 auf. Der untere Schaltungszweig weist eine Parallelschaltung aus einem sechsten Inverter INV6 und einem zweiten Transistorgate TG2 auf. Das erste Transistorgate TG1 besteht aus einer Parallelschaltung eines P-Kanal-MOS-Transistors T4 und eines N-Kanal-MOS-Transistors T5, während das zweite Transistorgate TG2 aus einer Parallelschaltung eines N-Kanal-MOS-Transistors T6 und eines P-Kanal-MOS-Transistors T7 besteht. Die Gates von T4 und T5 sind direkt bzw. über INV5 mit dem Ausgang OH des Pegelschiebers LS verbunden. Die Gates von T6 und T7 sind über INV6 bzw. direkt mit dem Ausgang OL von LS verbunden. Einem Eingang E1 des ersten Transfergates TG1 wird eine Spannung VLCDH und einem Eingang E2 des zweiten Transistorgates TG2 wird eine Spannung VLCDL zugeführt. Ausgänge A1 bzw. A2 von TG1 und TG2 sind gemeinsam mit dem Schaltungspunkt K und damit mit der Kontaktierungsfläche PAD verbunden.

In der Betriebsart, in welcher die in Fig. 7 gezeigte Schaltung als LCD-Treiberschaltung dient, ist mit PAD ein LCD-Pixel einer mit Anzeigepixeln (zum Beispiel matrixartig angeordneten, punktförmigen LCD-Anzeigeelementen) aufgebauten LCD-Anzeigevorrichtung verbunden. Die Information, ob das mit PAD verbundene LCD-Pixel in einen Anzeigezustand oder in einen Nicht-Anzeigezustand gebracht werden soll, wird von dem Ausgang LCD LATCH des LCD-Schieberegisters SR abgeleitet. Zu diesem Zweck wird über einen Anzeigeinformationseingang LCD IN des LCD-Schieberegisters SR Anzeigeinformation, die das an PAD angeschlossene spezielle Pixel betrifft, in das Schieberegister SR geschoben.

Für jedes Pixel der gesamten LCD-Anzeigevorrichtung ist eine Schaltung gemäß Fig. 7 vorgesehen. Daher enthält die Gesamt-Treiberschaltung für eine solche LCD-Anzeigevorrichtung auch eine Vielzahl von Schieberegistern SR, die über je einen Signaleingang LCD IN und einen Signalausgang LCD OUT miteinander verbunden sind. Die Gesamtanzeige der LCD-Anzeigevorrichtung wird dadurch vorbereitet, daß die den einzelnen Pixeln entsprechende Anzeigeinformation von einem ersten Schieberegister aus beginnend durch die einzelnen Schieberegister hindurchgeschoben wird, bis die ein erstes Pixel betreffende Anzeigeinformation in dem für dieses erste Pixel zuständigen letzten Schieberegister angekommen ist. Das Durchschieben der Anzeigeinformation durch die Schieberegister erfolgt mit Hilfe eines Schiebetaktes, der einem Takteingang LCD CLK eines jeden dieser Schieberegister SR zugeführt wird. Wenn die Anzeigeinformation soweit durch die Schieberegister-Reihenschaltung hindurchgeschoben ist, daß sich die Anzeigeinformation eines jeden Pixels in dem zugehörigen Schieberegister SR befindet, wird jedem dieser Schieberegister SR über einen weiteren Eingang LCD LD eine entsprechende Ladungszustandinformation gegeben. Danach dient jedes Schieberegister SR als Zwischenspeicher für die zugehörige Pixel-Anzeigeinformation, die dann von dem Ausgang LCD LATCH über den Pegelschieber LS und das LCD-Transfergate LTG auf die Kontaktierungsfläche PAD der zugehörigen Treiberschaltung und von dort an das zugehörige Pixelanzeigeelement gegeben wird.

Fig. 8 zeigt die den Eingängen E1 und E2 von TG1 bzw. TG2 zugeführten Spannungsverläufe VLCDH bzw. VLCDL in durchgezogener bzw. gestrichelter Darstellung. Ein Spannungsverlauf von LCDH aktiviert das zugehörige Pixel, bringt dieses also in einen Anzeigezustand. Der Spannungsverlauf VLCDL macht das zugehörige Pixel inaktiv, hält es also im Nicht-Anzeigezustand. Wenn der Pegelschieber LS über seinen Eingang ENABLE von AND1 dazu freigegeben ist, gibt der Pegelschieber LS in Abhängigkeit von der seinem Dateneingang DE vom Schieberegister SR gelieferten Anzeigeinformation ein Transfergate-Öffnungssignal entweder über seinen Ausgang OH an das erste Transistorgate TG1 oder über seinen Ausgang OL an das zweite Transistorgate TG2. In Abhängigkeit davon werden entweder T4 und T5 oder T6 und T7 leitend geschaltet, so daß über die Kontaktierungsfläche PAD entweder der Spannungsverlauf VLCDH oder der Spannungsverlauf VLCDL an das zugehörige LCD-Pixel gelangt.

Außerdem weist die in Fig. 7 gezeigte Mehrfachbetriebsartenschaltung einen Übertragungspfad für den Eingangsstufenbetrieb auf. Zu diesem Übertragungspfad gehört ein Schmitt-Trigger ST, dessen Eingang mit PAD und dessen Ausgang einerseits über einen schaltbaren Verstärker PIN SEL mit dem Datenbus DB und andererseits über einen geschalteten Puffer EN5 mit einem Eingang einer Vielfach-NAND-Schaltung NANDV verbunden ist. Die weiteren Eingänge von NANDV sind mit geschalteten Puffern parallel angeordneter anderer Mehrfachbetriebsartenschaltungen verbunden. Über den Ausgang von NANDV kann ein INTERRUPT-Signal abgegeben werden.

Geschaltete Verstärker DDR SEL, DR SEL und OR SEL dienen dazu, im Ausgangstufenbetrieb der Mehrfachbetriebsartenschaltung die in den Registern DDR, DR und OR enthaltene Dateninformation auf den Datenbus DB rücklaufenlassen zu können.

Im folgenden werden noch Betriebsarten, welche die in Fig. 7 gezeigte Mehrfachbetriebsartenschaltung annehmen kann, erläutert.

Ob sich diese Schaltung im Eingangs- oder im Ausgangsstufenbetrieb befindet und welche spezielle Betriebsart sie im Eingangs- bzw. im Ausgangsstufenbetrieb innehat, hängt von den Datenwerten ab, die in die Register DDR, DR und OR eingegeben sind.

Zunächst seien Betriebsarten betrachtet, in denen diese Schaltung als Ausgangsstufe fungiert.

Soll sie als LCD-Pixel-Treiber benutzt werden, werden in die Register der Registereinrichtung folgende Logikwerte eingegeben:
- DDR =: 0
- DR =: 1
- OR =: 1

Dem ENABLE-Eingang des Pegelschiebers LS wird der Logikwert 1 zugeführt, so daß LS freigegeben wird.

Aufgrund der in DDR, DR und OR befindlichen Logikwerte sind die Transistoren T1, T2 und T3 abgeschaltet. Aufgrund der Freigabe von LS kann in Abhängigkeit von der im Schieberegister SR befindlichen Anzeigeinformation über PAD entweder der die Pixelanzeige aktivierende Spannungsverlauf VLCDH oder der nicht zur Pixelanzeige führende Spannungsverlauf VLSDL gegeben werden.

Soll die Mehrfachbetriebsartenschaltung zur Ansteuerung einer LED (Licht emittierenden Diode) verwendet werden, werden in die Register der Registereinrichtung folgende Logikwerte eingegeben:
- DDR =: 1
- DR =: 0 oder 1 (je nachdem, ob die LED leuchten soll oder nicht)
- OR =: 1.

Dies führt dazu, daß die Transistoren T1 und T2 im Gegentaktbetrieb alternativ einschaltbar sind, wohingegen T3 permanent abgeschaltet ist.

Für die Betriebsart der sogenannten Open-Drain-Ansteuerung, bei welcher T1 permanent ausgeschaltet ist, so daß dessen an PAD liegendes Drainpotential bei gesperrt geschaltetem T2 schwimmend oder floatend ist, wird das Potential von PAD durch eine an PAD angeschlossene Last, beispielsweise in Form eines Widerstandes oder eines Relais, definiert. Für diese Betriebsart werden in die Registereinrichtung folgende Logikwerte eingegeben:
- DDR =: 1
- DR =: 1 oder 0
- OR =: 0.

Aufgrund dieser Logikwerte sind T1 und T3 dauernd gesperrt. Ob T2 sperrt oder leitet, hängt davon ab, ob der Logikwert in DR 1 oder 0 ist. Ist T2 leitend, befindet sich das Potential der Kontaktierungsfläche PAD auf Massepotential GND. Ist T2 gesperrt, befindet sich das Potential von PAD in undefinierter Weise irgendwo zwischen VDD und GND, weist somit ein undefiniertes, floatendes Potential auf. In diesem Fall wird das Potential von PAD ausschließlich durch die an PAD angeschlossene externe Last bestimmt.

Es werden nun noch Betriebsarten betrachtet, bei denen die Mehrfachbetriebsartenschaltung der Fig. 7 im Eingangsstufenbetrieb arbeitet.

In einer ersten Betriebsweise ist die Kontaktierungsfläche PAD mit einer externen Signalquelle verbunden, von welcher PAD von außen Datensignale zugeführt werden. Für diesen Fall sind die Transistoren T1, T2 und T3 immer gesperrt. Desweiteren ist der Pegelschieber LS dadurch gesperrt, daß er über den Eingang ENABLE nicht freigegeben wird.

Diese Betriebsart erreicht man beispielsweise dadurch, daß man in eines der beiden Register DDR und DR den Logikwert 0 und in das andere dieser beiden Register den Logikwert 1 eingibt. Auf diese Weise bleibt einzig und allein offen der Übertragungspfad, der von der Kontaktierungsfläche PAD über den Schmitt-Trigger ST und den Verstärker PIN SEL zum Datenbus DB führt.

Abschließend wird noch eine Eingangsstufenbetriebsart beschrieben, bei welcher die Transistoren T1 und T2 sowie der Pegelschieber LS gesperrt und lediglich der Widerstands-MOS-Transistor T3 leitend geschaltet ist. Zu diesem Zweck wird in die beiden Register DDR und DR je der Logikwert 0 eingegeben. Damit wird erreicht, daß sich an der Kontaktierungsfläche PAD ein definiertes Potential einstellt, das vom Spannungsabfall über T3 abhängt. In einer derartigen Betriebsart kann man mit dieser Mehrfachbetriebsartenschaltung beispielsweise die Schalterstellung eines an PAD angeschlossenen externen mechanischen Schalters detektieren. Ist der Schalter geschlossen, fließt über T3 ein Querstrom.

Wie bereits erwähnt, weist diese Mehrfachbetriebsartenschaltung eine Reihe von P-Kanal-MOS-Transistoren auf, die sich in einer n⁻-leitenden Wannenzone befinden, wie es in den Figuren 1 bis 3 gezeigt ist. Zur Vermeidung der geschilderten Probleme mit parasitären Dioden werden die Kontaktierungszonen solcher P-Kanal-MOS-Transistoren mit einem Wannenpotential VW beaufschlagt, das mindestens so groß ist wie der Betrag, den die beiden Potentiale VDD und VLCD maximal annehmen können. Welche P-Kanal-Transistoren der Mehrfachbetriebsartenschaltung und welche Schaltungsblöcke, welche in Fig. 7 nicht gezeigte P-Kanal-MOS-Transistoren enthalten, die Wannenspannung VW zugeführt bekommen, ist in Fig. 7 angegeben.

Bei der in Fig. 7 gezeigten Mehrfachbetriebsartschaltung sind die Wannenkontaktierungszonen mindestens derjenigen P-Kanal-Transistoren mit dem Wannenpotential VW verbunden, die mit der Kontaktierungsfläche PAD elektrisch verbunden oder verbindbar sind.

Den Wannenkontaktierungszonen solcher P-Kanal-Transistoren das Wannenpotential VW zuzuführen, führt zu einem weiteren Vorteil neben dem Sicherstellen des Sperrens parasitärer Dioden. Wenn man beispielsweise den P-Kanal-Transistor T1 betrachtet, läge dessen Wannenkontaktierungszone bei herkömmlicher Betriebsweise auf dem Versorgungsspannungspotential VDD. Wenn dann an der Kontaktierungsfläche PAD ein Potential VPAD > VDD läge und damit an der Drainzone von T1, würde die parasitäre Diode DWD von T1 leiten. Dadurch, daß an der Wannenkontaktierungszone von T1 das Wannenpotential VW liegt, das einen beträchtlich höheren Betrag aufweisen kann als VDD, können an PAD Potentiale erscheinen, die wesentlich höher sein können als VDD. Da man mit dem Betrag des Wannenpotentials bis zu der Spannungsverträglichkeitsgrenze gehen kann, die nur von der speziell verwendeten Halbleitertechnologie abhängt, kann das zulässige Potential von PAD wesentlich höher sein als der übliche Potentialwert von VDD.

Steuert man beispielsweise über PAD ein externes Relais an, kann es von großem Vorteil sein, dieses nicht mit dem Spannungswert von VDD betreiben zu müssen, sondern mit dem möglicherweise wesentlich höheren Spannungswert von VW.

Verwendet man die in Fig. 7 gezeigte Schaltung z. B. im Bereich der Kraftfahrzeugelektronik, hat man beispielsweise Batteriespannungen von 12 V verfügbar. Dies ist wesentlich mehr als die übliche Versorgungsspannung VDD von beispielsweise 4,5 V bis 5 V. Verwendet man die 12 V als Wannenpotential VW, kann man somit an PAD ein Potential von bis zu 12 V zulassen, ohne daß die parasitären Dioden von T1 leiten.

## Patentansprüche

1. Monolithisch integrierte Mehrfachbetriebsartenschaltung, welche aufweist:
a. eine erste CMOS-Ausgangsstufe mit einem niedrigpotentialseitig angeordneten ersten MOS-Transistor (T2) eines ersten Kanaltyps (N), einem hochpotentialseitig angeordneten ersten MOS-Transistor (T1) eines zweiten Kanaltyps (P) und einer zwischen diesen beiden Transistoren (T1, T2) angeordneten und mit diesen beiden Transistoren (T1, T2) verbundenen Kontaktierungsfläche (PAD) für eine elektrische Eingangs- oder Ausgangsverbindung mit externen Schaltungselementen;
b. einen dem ersten MOS-Transistor (T1) des zweiten Kanaltyps (P) parallelgeschalteten Widerstands-MOS-Transistor (T3), der als schaltbarer Widerstand dient und in einen Sperrzustand oder in einen leitenden Zustand, in dem dieser Transistor einen definierten Durchlaßwiderstand darstellt, steuerbar ist;
c. ein Transfer-Gate (LTG), das mindestens einen zweiten MOS-Transistor (T4, T7) des zweiten Kanaltyps (P) aufweist und in einen Transferzustand steuerbar ist, in dem das Transfer-Gate (LTG) Lasttreibersignale von einer Treibersignalquelle (SR) zu der Kontaktierungsfläche (PAD) überträgt;
d. einen Übertragungspfad (ST, PIN SEL), der mindestens einen dritten MOS-Transistor des zweiten Kanaltyps (P) aufweist und für eine Übertragung von über die Kontaktierungsfläche (PAD) eingehenden Signalen auf eine Signalverwertungsschaltung und/oder einen Datenbus (DB) der Mehrfachbetriebsartenschaltung betreibbar ist;
e. und eine Steuerschaltungsanordnung, der Steuersignale zuführbar sind und welche die Mehrfachbetriebsartenschaltung in Abhängigkeit von den Steuersignalen entweder in einen Ausgangsstufenbetrieb, in welchem die Mehrfachbetriebsartenschaltung Treibersignale an eine an die Kontaktierungsfläche (PAD) angeschlossene Last liefert, oder einen Eingangsstufenbetrieb, in welchem die Mehrfachbetriebsartenschaltung Eingangssignale von einer an die Kontaktierungsfläche (PAD) angeschlossenen Signalquelle erhält, steuert;
wobei die Steuerschaltungsanordnung
e.1 in dem Ausgangsstufenbetrieb
- entweder die beiden Transistoren (T1, T2) der CMOS-Ausgangsstufe und den Widerstands-MOS-Transistor (T3) nichtleitend und das Transfer-Gate (LTG) leitend steuert;
- oder den Widerstands-MOS-Transistor (T3) und das Transfer-Gate (LTG) nichtleitend und die beiden Transistoren (T1, T2) der CMOS-Ausgangsstufe im Gegentaktbetrieb leitend steuert;
- oder den hochpotentialseitigen Transistor (T1) der CMOS-Ausgangsstufe, den Widerstands-MOS-Transistor (T3) und das Transfer-Gate (LTG) nichtleitend und den niederpotentialseitigen Transistor (T3) der CMOS-Ausgangsstufe leitend steuert;
e.2 und in dem Eingangsstufenbetrieb
- entweder die beiden Transistoren (T1, T2) der CMOS-Ausgangsstufe, den Widerstands-MOS-Transistor (T3) und das Transfer-Gate (LTG) nichtleitend steuert, bei leitendem Übertragungspfad (ST, PIN SEL);
- oder die beiden Transistoren (T1, T2) der CMOS-Ausgangsstufe und das Transfer-Gate (LTG) nichtleitend und den Widerstands-MOS-Transistor (T3) leitend steuert;
f. wobei an der Kontaktierungsfläche (PAD) unterschiedliche Potentiale (VDD, VLCD) gleichen vorbestimmten Vorzeichens aber unterschiedlichen, möglicherweise veränderten Betrags auftreten können;
g. wobei die genannten Transistoren des zweiten Kanaltyps (P) in mindestens einer Wannenzone (W) mit einer Wannenkontaktierungszone (WK) angeordnet sind;
h. und wobei an die Wannenkontaktierungszone (WK) eines jeden den zweiten Kanaltyp (P) aufweisenden Transistors (z.B. T1, T4, T7), welcher mit der Kontaktierungsfläche (PAD) in Verbindung steht oder bringbar ist, ein Wannenpotential (VW) anlegbar ist, welches das vorbestimmte Vorzeichen aufweist und dessen Betrag mindestens so groß ist wie der maximale Betrag, den das Potential an der Kontaktierungsfläche (PAD) maximal annehmen kann.

2. Mehrfachbetriebsartenschaltung nach Anspruch 1, bei welcher die Transistoren des ersten Kanaltyps N-Kanal-MOS-Transistoren und die Transistoren des zweiten Kanaltyps P-Kanal-MOS-Transistoren sind und bei welcher das vorbestimmte Vorzeichen positiv ist.

3. Mehrfachbetriebsartenschaltung nach Anspruch 1 oder 2, bei welcher die Steuerschaltungsanordnung aufweist:
eine Registereinrichtung mit einem Datenflußrichtungsregister (DDR) zur Speicherung von die Datenflußrichtung der Mehrfachbetriebsartenschaltung festlegenden Steuerdaten, mit einem Datenregister (DR) zur Zwischenspeicherung von zu übertragenden Datensignalen und mit einem Optionsregister (OR) zur Speicherung von die möglichen Betriebsarten auswählenden Betriebsartendaten,
und eine zwischen die Registereinrichtung einerseits und die CMOS-Ausgangsstufe (T1, T2), den Widerstands-MOS-Transistor (T3) und das Transfergate (LTG) andererseits geschaltete und deren Steuerung bewirkende Logikschaltungsanordnung (NAND, NOR, AND1, AND2).

## Claims

1. A monolithic integrated multiple-mode circuit comprising:
a. a first CMOS output stage having a low potential side first MOS transistor (T2) of a first channel type (N), a high potential side first MOS transistor (T1) of a second channel type (P), and a contacting area (PAD) disposed between these two transistors (T1, T2), and connected to these two transistors (T1, T2) for an electric input or output connection with external circuit elements;
b. a resistor-MOS transistor (T3) connected in parallel to the first MOS transistor (T1) of the second channel type (P), said transistor (T3) serving as a switchable resistor and being drivable to an off-state or to an on-state in which this transistor constitutes a defined forward resistance;
c. a transfer gate (LTG) having at least a second MOS transistor (T4, T7) of the second channel type (P) and being drivable to a transfer state in which the transfer gate (LTG) transfers load driver signals from a driver signal source (SR) to the contacting area (PAD);
d. a transfer path (ST, PIN SEL) having at least a third MOS transistor of the second channel type (P) and being operable for a transfer of signals entering via the contacting area (PAD) to a signal exploitation circuit and/or a data bus (DB) of the multiple-mode circuit;
e. and a control circuit arrangement to which control signals can be supplied and which drives the multiple-mode circuit in accordance with the control signals either into an output stage mode, in which the multiple-mode circuit provides driver signals to a load connected to the contacting area (PAD), or into an input stage mode, in which the multiple-mode circuit receives input signals from a signal source connected to the contacting area (PAD); in which said control circuit arrangement
e.1 in the output stage mode
- renders the two transistors (T1, T2) of the CMOS output stage and the resistor-MOS transistor (T3) non-conducting and the transfer gate (LTG) conducting;
- or renders the resistor-MOS-transistor (T3) and the transfer gate (LTG) non-conducting and the two transistors (T1, T2) of the CMOS output stage in push-pull operation conducting;
- or renders the high potential side transistor (T1) of the CMOS output stage, the resistor-MOS transistor (T3) and the transfer gate (LTG) non-conducting and the low potential side transistor (T3) of the CMOS output stage conducting;
e.2 and in the input stage mode
- either renders the two transistors (T1, T2) of the CMOS output stage, the resistor-MOS transistor (T3) and the transfer gate (LTG) non-conducting while the transfer path (ST, PIN SEL) is conducting;
- or renders the two transistors (T1, T2) of the CMOS output stage and the transfer gate (LTG) non-conducting and the resistor-MOS transistor (T3) conducting;
f. with the possibility of different potentials (VDD, VLCD) of the same predetermined sign, but different, possibly variable amount being present at the contacting area (PAD):
g. with said transistors of the second channel type (P) being disposed in at least one well region (W) having a well contacting region (WK);
h. and with the possibility that the well contacting region (WK) of each transistor (e.g. T1, T4, T7) of the second channel type (P), which is or may be connected to the contacting area (PAD), has a well potential applied thereto which has the predetermined sign and whose amount is at least as great as the maximum amount which the potential at the contacting pad (PAD) can assume at maximum.

2. The multiple-mode circuit of claim 1,
wherein the transistors of the first channel type are N-channel MOS transistors and the transistors of the second channel type are P-channel MOS transistors, and wherein the predetermined sign is positive.

3. The multiple-mode circuit of claim 1 or 2,
wherein the control circuit arrangement comprises:
a register means having a data flow direction register (DDR) for storing control data determining the data flow direction of the multiple-mode circuit, a data register (DR) for temporarily storing data signals to be transferred, and
an option register (OR) for storing mode data selecting the possible modes, and a logic circuit arrangement (NAND, NOR, AND1, AND2) connected between the register means on the one hand and the CMOS output state (T1, T2), the resistor-MOS transistor (T3) and the transfer gate (LTG) on the other hand and effecting the control thereof.

## Revendications

1. Circuit intégré monolithique à plusieurs modes d'opération,qui présente :
a. un premier niveau de sortie CMOS avec un premier transistor MOS (T2) disposé côté faible potentiel, d'un premier type de canal (N), un premier transistor MOS (T1) disposé côté potentiel élevé d'un second type de canal (P) et une surface d'établissement de contact (PAD) disposée entre ces deux transistors (T1, T2) et reliée à ces deux transistors (T1, T2) pour une liaison électrique d'entrée ou de sortie avec des éléments de circuit externes ;
b. un transistor MOS à résistance (T3) branché parallèlement au premier transistor MOS (T1) du second type de canal (P), qui sert de résistance commutable et peut être commandé dans un état de blocage ou dans un état conducteur, dans lequel ce transistor représente une résistance directe définie ;
c. un portail de transfert (LTG), qui présente au moins un second transistor (MOS) (T4, T7) du second type de canal (P) et peut être commandé dans un état de transfert, dans lequel le portail de transfert (LTG) transmet des signaux de porteuse de charge d'une source de signal de porteuse (SR) à la surface d'établissement de contact (PAD) ;
d. un chemin de transmission (ST, PIN, SEL), qui présente au moins un troisième transistor MOS du second type de canal (P) et peut être exploité pour une transmission de signaux arrivant par la surface d'établissement de contact (PAD) sur un circuit d'exploitation de signal et/ou un bus de données (DB) du circuit à plusieurs modes d'opération ;
e. et un agencement de circuit de commande, auquel des signaux de commande peuvent être amenés et qui commande le circuit à plusieurs modes d'opération en fonction des signaux de commande soit pour un fonctionnement en étage de sortie, dans lequel le circuit à plusieurs modes d'opération fournit des signaux de porteuse à une charge raccordée à la surface d'établissement de contact (PAD), soit par un fonctionnement en étage d'entrée, dans lequel le circuit à plusieurs modes d'opération reçoit des signaux d'entrée d'une source de signal raccordée à la surface d'établissement de contact (PAD) ; l'agencement de circuit de commande,
e.1 dans le fonctionnement en étage de sortie,
- commandant en mode non conducteur les deux transistors (T1, T2) de l'étage de sortie CMOS et le transistor MOS à résistance (T3) et commandant en mode conducteur le portail de transfert (LTG) ;
- ou commandant en mode non conducteur le transistor MOS à résistance (T3) et le portail de transfert (LTG) et commandant en mode conducteur les deux transistors (T1, T2) de l'étage de sortie CMOS dans l'exploitation symétrique ;
- ou commandant en mode non conducteur le transistor (T1) côté potentiel élevé de l'étage de sortie CMOS, le transistor MOS à résistance (T3) et le portail de transfert (LTG) et commandant en mode conducteur le transistor (T3) côté faible potentiel de l'étage de sortie CMOS;
e.2 et dans le fonctionnement en étage d'entrée,
- commandant en mode non conducteur les deux transistors (T1, T2) de l'étage de sortie CMOS, le transistor MOS à résistance (T3) et le portail de transfert (LTG), avec un chemin de transmission conducteur (ST, PIN, SEL) ;
- ou commandant en mode non conducteur les deux transistors (T1, T2) de l'étage de sortie CMOS et le portail de transfert (LTG) et commandant en mode conducteur le transistor MOS à résistance (T3) ;
f. différents potentiels (VDD, VLCD) de signe défini identique, mais de valeur différente, éventuellement modifiée, pouvant apparaître sur la surface d'établissement de contact (PAD) ;
g. les transistors cités du second type de canal (P) étant disposés dans au moins une zone de puits (W) avec une zone d'établissement de contact de puits (WK) ;
h. et un potentiel de puits (VW) étant appliqué sur la zone d'établissement de contact de puits (WK) de chaque transistor (par exemple T1, T4, T7), présentant le même type de canal (P), qui est en liaison ou peut être amené en liaison avec la surface d'établissement de contact (PAD), lequel potentiel présente le signe prédéfini et dont la valeur est au moins aussi grande que la valeur maximum que le potentiel peut prendre au maximum sur la surface d'établissement de contact.

2. Circuit à plusieurs modes d'opération selon la revendication 1, sur lequel les transistors du premier type de canal sont des transistors MOS à canal N et les transistors du second type de canal sont des transistors MOS à canal P et sur lequel le signe prédéfini est positif.

3. Circuit à plusieurs modes d'opération selon la revendication 1 ou 2, sur lequel l'agencement de portail de transfert présente : un dispositif de registre avec un registre de direction de flux de données (DDR) pour le stockage de données de commande fixant le sens de flux de données du circuit à plusieurs modes d'opération, avec un registre de données (DR) pour le stockage intermédiaire de signaux de données à transmettre et avec un registre d'option (OR) pour le stockage de données de modes d'opération sélectionnant les modes d'opération possibles,
et un agencement de circuit logique (NAND, NOR, AND1, AND2) commuté entre le dispositif de registre d'une part et l'étage sortie CMOS (T1, T2), le transistor MOS à résistance (T3) et le portail de transfert (LTG) d'autre part et réalisant sa commande.
